# FASCICULE DE BREVET EUROPEEN

(11) **EP 3 591 724 B1**
(45) Date de publication et mention de la délivrance du brevet: **19.05.2021**
(21) Numéro de dépôt: 19181167.8
(22) Date de dépôt: 19.06.2019
(51) Int. Cl.: H01L 41/313

(54) **PROCEDE DE REALISATION D'UN DISPOSITIF TRANSDUCTEUR PIEZOELECTRIQUE**
VERFAHREN ZUR REALISIERUNG EINER PIEZOELEKTRISCHEN WANDLERVORRICHTUNG
METHOD FOR REALISING A PIEZOELECTRIC TRANSDUCER DEVICE

(30) Priorité: 22.06.2018 FR 1855593
(43) Date de publication de la demande: 08.01.2020
(73) Titulaire: Commissariat à l'énergie atomique et aux énergies alternatives, 75015 Paris (FR)
(72) Inventeur: LE RHUN, Gwenaël, 38054 GRENOBLE CEDEX 09 (FR)
(74) Mandataire: Brevalex

(56) Documents cités:
- US-A1- 2002 066 525
- US-A1- 2003 196 745
- US-A1- 2005 067 920
- GOTO H ET AL: "Micro focusing optical device using piezoelectric thin film actuator", MICRO-OPTICS/MICROMECHANICS AND LASER SCANNING AND SHAPING, 7-9 FEBRUARY 1995, SAN JOSE, CA; SPIE PROCEEDINGS, vol. 2383, 1995, pages 136-143, XP055565811, ISSN: 0277-786X, DOI: 10.1117/12.209015
- KANNO I ET AL: "Development of Deformable Mirror Composed of Piezoelectric Thin Films for Adaptive Optics", IEEE JOURNAL OF SELECTED TOPICS IN QUANTUM ELECTRONICS, vol. 13, no. 2, mars 2007 (2007-03), pages 155-161, XP011179420, ISSN: 1077-260X, DOI: 10.1109/JSTQE.2007.894065

## Description

### DOMAINE TECHNIQUE ET ART ANTÉRIEUR

L'invention porte sur la réalisation d'un dispositif transducteur piézoélectrique à matériau piézoélectrique de structure cristalline pérovskite, notamment de type MEMS (microsystème électromécanique) et/ou NEMS (nanosystème électromécanique). L'invention s'applique avantageusement à la réalisation de dispositifs transducteurs piézoélectriques correspondant à des actionneurs, des capteurs ou encore des dispositifs de récupération d'énergie vibratoire. L'invention peut s'appliquer également à la réalisation de capteurs pyroélectriques (le matériau pyroélectrique étant aussi piézoélectrique).

Lors de la réalisation d'un dispositif transducteur à matériau piézoélectrique de structure cristalline pérovskite, le matériau piézoélectrique est déposé sur un substrat de silicium à partir duquel une membrane de silicium est réalisée, ou directement sur une membrane de silicium ou de nitrure de silicium disposée sur un substrat. Pour mettre en œuvre correctement ce dépôt, la présence d'une couche de SiO₂ entre le matériau piézoélectrique et le silicium ou le nitrure de silicium est nécessaire afin d'éviter des décollements pouvant survenir à l'interface entre le matériau piézoélectrique et le silicium ou le nitrure de silicium suite au recuit de cristallisation du matériau piézoélectrique qui est mis en œuvre à haute température (par exemple à environ 700°C). Cela est particulièrement critique lorsque le matériau piézoélectrique, correspondant par exemple à du PZT (Pb(Zr_{X},Ti_{1-X})O₃), est déposé par un procédé sol-gel. En outre, la couche de SiO₂ joue le rôle de barrière de diffusion pour le plomb provenant du PZT et qui est diffusé lors du recuit du PZT.

La couche de SiO₂ présente entre le matériau piézoélectrique et le silicium ou le nitrure de silicium n'est toutefois pas toujours souhaitable. Par exemple, cette couche de SiO₂ peut être contraignante en raison de la contrainte compressive qu'elle apporte au sein de l'empilement de matériaux du dispositif transducteur piézoélectrique.

Un autre problème rencontré lors de la réalisation d'un tel dispositif transducteur à matériau piézoélectrique de structure cristalline pérovskite et qui comporte des électrodes interdigitées disposées sur une seule face de la couche piézoélectrique est l'absence de couche de métallique, par exemple de platine, entre la couche piézoélectrique et le substrat ou la membrane de silicium ou de nitrure de silicium, rendant la croissance du matériau piézoélectrique sur le substrat ou la membrane très compliquée
La réalisation de transducteurs piézoélectriques par dépôt d'une électrode inférieure en Pt et d'une couche piézoélectrique PZT directement sur une couche membrane de SiN ou Si est connue de Goto H et al, Proc. SPIE, vol. 2383, pages 136-143, Kanno I et al, IEEE JOURNAL OF SELECTED TOPICS IN QUANTUM ELECTRONICS, vol. 13, no. 2, 2007, pages 155-161, et US 2005/067920 A1, par exemple.

US 2003/196745 A1 divulgue un procédé de fabrication d'un dispositif actionneur piézoélectrique, comportant des étapes de réalisation d'une couche piézoélectrique cristalline pérovskite sur un premier substrat, solidarisation de la couche piézoélectrique à un deuxième substrat, formant un empilement dans lequel une membrane comprenant une couche de Si est disposée entre la couche piézoélectrique et le deuxième substrat telle que la couche piézoélectrique est en contact avec la couche de Si uniquement par l'intermédiaire de plusieurs couches métalliques, séparation mécanique au niveau d'une interface entre la couche piézoélectrique et le premier substrat, et réalisation des électrodes en contact électriquement avec la couche piézoélectrique.

US 2002/066525 A1 décrit une méthode semblable de transfert d'une couche de PZT d'un substrat donneur, par exemple en MgO ou Si, sur une couche de membrane, bien qu'en verre Pyrex recouvrant un substrat récepteur en Si, en utilisant une couche de séparation en ZnO (éventuellement recouverte par une couche de SiN) qui a été préalablement formée sur le substrat donneur et qui est ensuite dissoute par l'acide acétique pour effectuer la séparation.

### EXPOSÉ DE L'INVENTION

Un but de la présente invention est de proposer un procédé de réalisation d'un dispositif transducteur à matériau piézoélectrique de structure cristalline pérovskite dont la structure permet, lors de sa réalisation, d'éviter les décollements pouvant survenir sous le matériau piézoélectrique lors de sa réalisation, et cela sans la présence d'une couche de SiO₂ sous le matériau piézoélectrique, et résolvant également les problèmes de réalisation du matériau piézoélectrique rencontrés lorsque les électrodes du dispositif ne sont disposées que sur une seule face de la couche piézoélectrique.

Pour cela, il est proposé le procédé de réalisation d'un dispositif transducteur piezoélectrique selon la revendication 1.

Avec un tel procédé, le dispositif transducteur piézoélectrique est donc réalisé en formant la couche piézoélectrique non pas sur la couche de silicium et/ou de nitrure de silicium de la membrane, mais sur un substrat temporaire. La couche piézoélectrique peut donc être transférée sur le substrat final après avoir subi un ou plusieurs recuits de cristallisation, ce qui n'endommage pas l'interface formée sous la couche piézoélectrique après son transfert sur le substrat final. Aucune couche de SiO₂ n'est donc nécessaire entre la couche de silicium et/ou de nitrure de silicium de la membrane et la couche piézoélectrique, sans que cela puisse engendrer des problèmes de décollement de la couche piézoélectrique.

L'absence de couche de SiO₂ à l'interface entre la membrane et la couche piézoélectrique a également pour conséquence de ne pas ajouter de contrainte compressive à cet endroit de l'empilement réalisé.

De plus, la couche piézoélectrique peut être en contact direct avec la couche de silicium et/ou de nitrure de silicium de la membrane, sans couche métallique entre la membrane et la couche piézoélectrique, car étant donné que la couche piézoélectrique est réalisée sur un substrat temporaire, une couche métallique servant à la réalisation de la couche piézoélectrique ne se retrouve pas entre la couche piézoélectrique et la membrane.

La membrane peut être formée d'au moins une couche de silicium, ou d'au moins une couche de nitrure de silicium, ou d'un empilement d'au moins une couche de silicium et d'au moins une couche de nitrure de silicium.

En variante, la membrane peut comporter au moins une couche de SiO₂ disposée entre deux couches de silicium et/ou de nitrure de silicium. Dans ce cas, la couche de SiO₂ n'est pas en contact direct avec la couche piézoélectrique.

Les première et deuxième électrodes sont en contact électriquement avec la couche piézoélectrique, c'est-à-dire sont soit en contact direct avec la couche piézoélectrique, soit en contact avec celle-ci par l'intermédiaire d'une ou plusieurs couches électriquement conductrices.

Lorsque la couche piézoélectrique est en contact direct avec la couche de silicium et/ou de nitrure de silicium de la membrane, aucun matériau intermédiaire n'est présent entre la couche piézoélectrique et la couche de silicium et/ou de nitrure de silicium de la membrane. Lorsque la couche piézoélectrique est en contact avec la couche de silicium et/ou de nitrure de silicium de la membrane uniquement par l'intermédiaire d'une ou plusieurs couches électriquement conductrices, cela signifie notamment qu'aucun matériau diélectrique tel que du SiO₂ n'est présent entre la membrane et la couche piézoélectrique.

La première électrode peut être disposée contre (directement ou non, c'est-à-dire avec éventuellement un ou plusieurs matériaux électriquement conducteurs présent entre la première électrode et la couche piézoélectrique) une première face de la couche piézoélectrique, et la deuxième électrode peut être disposée du côté d'une deuxième face de la couche piézoélectrique opposée à la première face de la couche piézoélectrique, entre la couche piézoélectrique et la couche de silicium et/ou de nitrure de silicium de la membrane. Un ou plusieurs matériaux électriquement conducteurs peuvent être présents entre la deuxième électrode et la couche piézoélectrique.

Les première et deuxième électrodes peuvent être disposées contre (directement ou non, c'est-à-dire avec éventuellement un ou plusieurs matériaux électriquement conducteurs présents entre les première et deuxième électrodes et la couche piézoélectrique) une première face de la couche piézoélectrique, et la couche de silicium et/ou de nitrure de silicium de la membrane peut être en contact direct avec une deuxième face de la couche piézoélectrique opposée à la première face de la couche piézoélectrique.

De manière avantageuse, le matériau piézoélectrique peut être du PZT.

Dans ce procédé, l'interface au niveau de laquelle la séparation mécanique est réalisée peut être définie au préalable par un choix judicieux des matériaux des première et deuxième couches de séparation engendrant naturellement une faible force d'adhérence à cette interface. En utilisant d'un côté un métal noble et de l'autre du SiO₂ et/ou du nitrure de silicium pour former les première et deuxième couches de séparation, une faible force d'adhérence est obtenue à l'interface de ces deux couches de séparation, sans avoir à mettre en œuvre d'étape spécifique. Ainsi, après avoir solidarisé la couche piézoélectrique au deuxième substrat, la séparation mécanique réalisée au niveau de l'interface entre les première et deuxième couches de séparation ne dégrade pas les autres couches car c'est l'interface entre les première et deuxième couches de séparation qui présente la plus faible force d'adhérence parmi toutes les interfaces de l'empilement de matériaux obtenu après la solidarisation.

L'utilisation d'un métal noble pour former l'une des première et deuxième couches de séparation a pour avantage d'éviter une oxydation de cette couche de séparation au contact de l'autre couche de séparation qui comporte le SiO₂ et/ou le nitrure de silicium, notamment lorsque des budgets thermiques importants sont atteints au cours du procédé, par exemple à des températures supérieures à environ 450°C, comme c'est le cas lorsque le matériau de structure cristalline pérovskite est cristallisé / densifié .

En variante ou en complément de la réalisation des première et deuxième couches de séparation à partir d'un métal noble et de SiO₂ et/ou de nitrure de silicium, la force d'adhérence à l'interface entre les première et deuxième couches de séparation peut être réduite en mettant en œuvre une étape spécifique, comme par exemple la formation de cavités à cette interface.

Le métal utilisé pour former l'une des première et deuxième couches de séparation peut correspondre à un métal résistant à l'oxydation.

Le procédé de transfert décrit ici peut avantageusement servir à la réalisation de composants formant des transducteurs électromécaniques intégrant des matériaux qui vont permettre de réaliser des fonctions d'actionneur et/ou de capteur. La fonction capteur est obtenue par l'effet piézoélectrique direct (une contrainte mécanique entraîne l'apparition de charges électriques dans le matériau) tandis que la fonction actionneur est obtenue par effet piézoélectrique inverse (dans ce cas une polarisation électrique externe au matériau entraîne une déformation mécanique de ce dernier).

De plus, à l'issue de la séparation mécanique à l'interface entre les première et deuxième couches de séparation, le premier substrat n'est pas détruit et peut être réutilisé.

Dans l'ensemble du document, le terme « sur » est utilisé sans distinction de l'orientation dans l'espace de l'élément auquel ce rapporte ce terme. Par exemple, dans la caractéristique « sur une face du premier substrat », cette face du premier substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

L'expression « toutes les interfaces de l'empilement » désigne toutes les interfaces formées entre deux couches successives (disposées l'une directement contre l'autre) de l'empilement.

La couche de séparation comportant du SiO₂ et/ou du nitrure de silicium peut correspondre à une couche de SiO₂ ou de nitrure de silicium, ou à un empilement de SiO₂ et de nitrure de silicium.

Le métal noble correspond à l'un ou plusieurs des matériaux suivants : platine (Pt), or (Au), argent (Ag), rhodium (Rh), osmium (Os), palladium (Pd), ruthénium (Ru), iridium (Ir).

Lorsque le métal noble est destiné à être exposé à de forts budgets thermiques, par exemple jusqu'à une température égale à environ 850°C, ce métal noble comporte avantageusement du platine et/ou du palladium. Lorsque le métal noble est destiné à être exposé à des températures moins importantes, comme par exemple des températures inférieures ou égales à environ 400°C, les autres métaux nobles (Au, Ag, Rh, Os, Ru, Ir) peuvent être utilisés pour former cette couche de métal noble.

La force d'adhérence de l'interface entre les première et deuxième couches de séparation peut être inférieure ou égale à environ 1,5 J/m², ou de préférence inférieure ou égale à environ 1 J/m². A titre d'exemple, la force d'adhérence entre les première et deuxième couches de séparation avec l'une comprenant du SiO₂ et l'autre du platine est égale à environ 1 J/m².

La force d'adhérence entre deux couches de matériaux peut être mesurée par la méthode dite d'insertion de lame décrite par exemple dans le document W. P. Mazsara et al., « Bonding of silicon wafers for silicon-on-insulator », Journal of Applied Physics 64, p. 4943, 1988).

Le premier substrat peut comporter du semi-conducteur, par exemple du silicium.

Le deuxième substrat peut comporter du semi-conducteur, par exemple du silicium.

Le procédé peut comporter en outre, entre l'étape de réalisation de la couche piézoélectrique et l'étape de solidarisation de la couche piézoélectrique au deuxième substrat, une étape de réalisation, sur la couche piézoélectrique, d'une première couche de collage comprenant du silicium et/ou du nitrure de silicium, et :
- l'étape de solidarisation peut être mise en œuvre par un collage direct entre la première couche de collage et une deuxième couche de collage comprenant du silicium et/ou du nitrure de silicium et disposée sur le deuxième substrat ;
- la réalisation de la membrane peut comporter une étape de réalisation d'une cavité dans le deuxième substrat telle qu'une partie des première et deuxième couches de collage disposée en regard de la cavité forme la membrane.

Ainsi, les première et deuxième couches de collage servent à la fois au report des couches du dispositif sur le deuxième substrat et à la formation de la membrane.

De plus, le procédé peut comporter en outre, entre l'étape de réalisation de la couche piézoélectrique et l'étape de réalisation de la première couche de collage, une étape de réalisation, sur la couche piézoélectrique, d'au moins une couche métallique configurée pour former la deuxième électrode du dispositif, et dans lequel la première électrode est réalisée sur la couche piézoélectrique après l'étape de séparation mécanique.

De manière avantageuse, la deuxième couche de séparation peut comporter le métal noble, et la première électrode peut être réalisée en gravant la deuxième couche de séparation telle qu'au moins une portion restante de la deuxième couche de séparation forme la première électrode. Ainsi, outre son rôle pour l'obtention d'une faible force d'adhérence entre les première et deuxième couches de séparation, cette deuxième couche de séparation peut être conservée, après l'étape de séparation mécanique, pour former la première électrode du dispositif.

En variante, la première couche de collage peut être réalisée directement contre la couche piézoélectrique, et les première et deuxième électrodes peuvent être réalisées sur la couche piézoélectrique après l'étape de séparation mécanique.

De manière avantageuse, la deuxième couche de séparation peut comporter le métal noble, et les première et deuxième électrodes peuvent être réalisées en gravant la deuxième couche de séparation telle que des portions restantes de la deuxième couche de séparation forment les première et deuxième électrodes ayant un motif de peignes interdigités. Là encore, la deuxième couche de séparation sert à l'obtention d'une faible force d'adhérence entre les première et deuxième couches de séparation, et, après l'étape de séparation mécanique, sert à former la première électrode du dispositif.

En outre, la première couche de collage peut comporter une première couche de silicium et/ou de nitrure de silicium et une première couche de SiO₂ telles que la première couche de silicium et/ou de nitrure de silicium soit disposée entre la première couche de SiO₂ et la couche piézoélectrique, et la deuxième couche de collage peut comporter une deuxième couche de silicium et/ou de nitrure de silicium et une deuxième couche de SiO₂ telles que la deuxième couche de silicium et/ou de nitrure de silicium soit disposée entre la deuxième couche de SiO₂ et le deuxième substrat.

En variante, le procédé peut comporter en outre, entre l'étape de réalisation de la couche piézoélectrique et l'étape de solidarisation de la couche piézoélectrique au deuxième substrat, une étape de réalisation, sur la couche piézoélectrique, d'une première couche de collage métallique, et :
- l'étape de solidarisation peut être mise en œuvre par un collage direct ou par thermocompression entre la première couche de collage métallique et une deuxième couche de collage métallique solidarisée au deuxième substrat par l'intermédiaire de la couche de silicium et/ou de nitrure de silicium de la membrane ;
- la réalisation de la membrane peut comporter une étape de réalisation d'une cavité dans le deuxième substrat telle qu'une partie de la couche de silicium et/ou de nitrure de silicium disposée en regard de la cavité forme au moins une partie de la membrane ;
- les première et deuxième couches de collage métalliques peuvent former ensemble la deuxième électrode du dispositif.

De manière avantageuse, la deuxième couche de séparation peut comporter le métal noble, et la première électrode peut être réalisée en gravant la deuxième couche de séparation telle qu'au moins une portion restante de la deuxième couche de séparation forme la première électrode.

Avantageusement, le métal noble peut comporter du platine, notamment lorsque la deuxième couche de séparation comportant le métal noble est destinée à former au moins l'une des électrodes du dispositif.

Selon un mode de réalisation particulier, le procédé peut être tel que :
- le matériau piézoélectrique comporte du plomb ;
- la première couche de séparation comporte du SiO₂ ;
- ladite au moins une étape réduisant la force d'adhérence initiale de l'interface entre les première et deuxième couches de séparation comporte la mise en œuvre d'au moins un traitement thermique formant, à l'interface entre les première et deuxième couches de séparation, un alliage de plomb et de SiO₂ en phase liquide, puis d'un refroidissement formant des cavités à l'interface entre les première et deuxième couches de séparation.

De telles cavités contribuent, seules ou en complément des matériaux choisis pour former les première et deuxième couches de séparation, à l'obtention de la faible force d'adhérence à l'interface entre les première et deuxième couches de séparation.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent un dispositif de transduction piézoélectrique selon l'art antérieur ;
- les figures 3A à 3C représentent les étapes d'un procédé de réalisation du dispositif de transduction piézoélectrique selon le premier mode de réalisation d'invention ;
- les figures 4A à 4C représentent les étapes d'un procédé de réalisation du dispositif de transduction piézoélectrique selon le deuxième mode de réalisation d'invention ;
- les figures 5A à 5C représentent les étapes d'un autre procédé de réalisation du dispositif de transduction piézoélectrique selon le premier mode de réalisation d'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

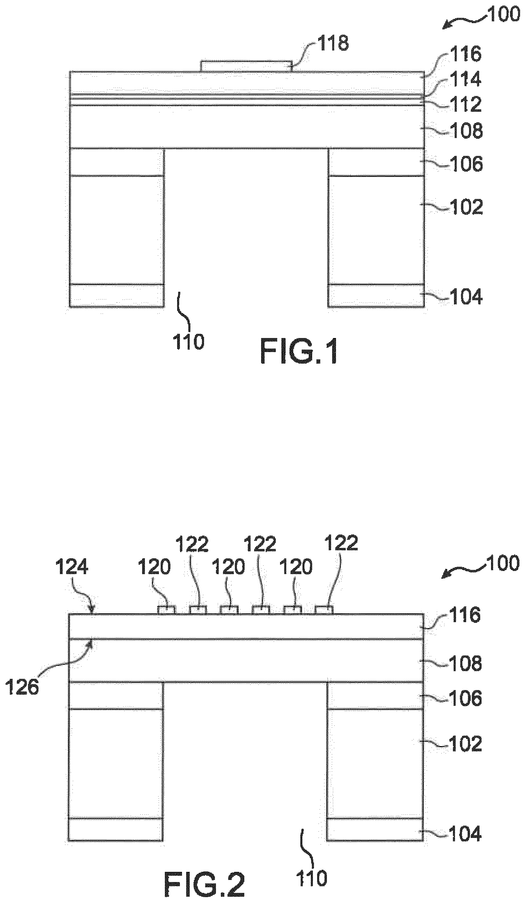

Un dispositif 100 de transduction piézoélectrique selon un premier mode de réalisation, connu des documents cités ci-dessus, est décrit ci-dessous en lien avec la figure 1.

Le dispositif 100 comporte un substrat 102 servant de support mécanique. Le substrat 102 comporte ici du semi-conducteur, par exemple du silicium. L'épaisseur du substrat 102 est par exemple comprise entre environ 100 µm et 1 mm.

Lors de la réalisation du dispositif 100, le substrat 102 est soumis à une oxydation de ses faces avant et arrière. Cette oxydation forme une première couche d'oxyde 104 (du SiO₂ dans le cas présent) contre sa face arrière et une deuxième couche d'oxyde 106 (également du SiO₂ dans le cas présent) contre sa face avant. Chacune des première et deuxième couches d'oxyde 104, 106 a par exemple une épaisseur comprise entre environ 0,5 µm et 1 µm (ici égale à environ 500 nm). La deuxième couche d'oxyde 106 sert notamment, lors de la réalisation du dispositif 100, de couche d'arrêt de gravure lors de la libération de la membrane du dispositif 100 depuis la face arrière du substrat 102.

Le dispositif 100 comporte également au moins une couche de silicium et/ou de nitrure de silicium disposée sur la deuxième couche d'oxyde 106 et qui forme une membrane 108 du dispositif 100 grâce à une cavité 110 formée à travers les première et deuxième couches d'oxyde 104, 106 et à travers le substrat 102 (la cavité 110 étant gravée lors de la libération de la membrane 108). L'épaisseur de la membrane 108 est par exemple égale à environ 1 µm et par exemple comprise entre environ 10 nm et 20 µm. La membrane 108 peut comporter à la fois du silicium et du nitrure de silicium lorsqu'elle est formée d'un empilement de ces matériaux. En variante, il est possible que la membrane 108 comporte une couche de SiO₂ disposée entre deux couches de silicium et/ou de nitrure de silicium.

Le dispositif 100 comporte également une électrode, appelée deuxième électrode 112, disposée sur la membrane 108. La deuxième électrode 112 comporte un matériau électriquement conducteur, par exemple du platine et/ou du ruthénium et/ou de l'iridium, du RuO₂, de l'Au, du Cu, etc., et une épaisseur qui est par exemple comprise entre environ 1 nm et 500 nm. Dans l'exemple de réalisation décrit ici, la deuxième électrode 112 comporte du platine et a une épaisseur égale à environ 100 nm.

Le dispositif 100 comporte également, sur la deuxième électrode 112, une couche d'accroche 114 optionnelle et servant, lors de la réalisation du dispositif 100, à améliorer la qualité de dépôt du matériau électriquement conducteurformant la deuxième électrode 112. La présence ou non de la couche d'accroche 114 est fonction notamment de l'adhérence de la deuxième électrode 112 sur la couche piézoélectrique 116. La couche d'accroche 114 comprend par exemple du ruthénium et/ou du tungstène et/ou du chrome et/ou du titane et/ou du TiO₂, et une épaisseur par exemple comprise entre environ 0 nm et 10 nm. Dans l'exemple de réalisation décrit ici, la couche d'accroche 114 comporte du ruthénium et une épaisseur égale à environ 5 nm.

Le dispositif 100 comporte également une couche piézoélectrique 116 disposée sur la couche d'accroche 114 (ou sur la deuxième électrode 112 en l'absence de la couche d'accroche 114) et comprenant un matériau piézoélectrique à structure cristalline pérovskite. Ce matériau piézoélectrique correspond par exemple à du PZT (dopé ou non avec du La, du Mn ou du Nb), du KNN (KₓNa_{1-X}NbO₃), du BST (Ba_{X}Sr_{1-X}TiO₃), du BCTZ (Ba(Ti_{X}Zr_{1-X})O₃-(Ba_{Y}Ca_{1-Y})TiO₃), du PMN-PT (PbMg_{1/3}Nb_{2/3}O₃-PbTiO₃) ou du NBT-BT (Na_{X}Bi_{Y}TiO₃-BaTiO₃), et dont l'épaisseur est par exemple comprise entre environ 1 nm et 100 µm et ici égale à environ 500 nm.

Lorsque le dispositif 100 correspond à un actionneur, le matériau piézoélectrique de la couche piézoélectrique 116 peut présenter un coefficient piézoélectrique transverse de coefficient d31 le plus élevé possible. C'est le cas du PZT (ou du PZT dopé (La, Mn, Nb)), du KNN, du NBT-BT, ou encore du PMN-PT. Lorsque le dispositif 100 correspond à un capteur, le matériau piézoélectrique de la couche piézoélectrique 116 peut être choisi tel qu'il présente le meilleur compromis entre un fort coefficient piézoélectrique transverse e31 et une faible permittivité diélectrique εᵣ, c'est-à-dire avec la plus grande Figure de Mérite FOM= e31/εᵣ. Enfin, il est possible que le dispositif 100 corresponde à un dispositif formant à la fois un actionneur et un capteur.

Enfin, le dispositif 100 comporte une autre électrode, appelée première électrode 118, disposée sur la couche piézoélectrique 116. Comme la deuxième électrode 112, la première électrode 118 comporte un matériau électriquement conducteur, par exemple du platine et/ou du ruthénium et/ou de l'iridium, et une épaisseur qui est par exemple comprise entre environ 1 nm et 500 nm et ici égale à environ 100 nm. Le matériau et/ou l'épaisseur de la première électrode 118 peuvent être similaires au matériau et/ou à l'épaisseur de la deuxième électrode 112. De manière avantageuse, lorsque la couche piézoélectrique 116 est formée (lors de la réalisation du dispositif 100) sur la couche servant à former la première électrode 118, la première électrode 118 comporte du platine afin de faciliter la croissance du matériau piézoélectrique de la couche piézoélectrique 116.

Dans ce premier mode de réalisation, les électrodes 112, 118 du dispositif 100 sont disposées chacune d'un côté de la couche piézoélectrique 116. Le dispositif 100 selon ce premier mode de réalisation fonctionne donc en utilisant le coefficient piézoélectrique transverse d31 du matériau piézoélectrique.

Dans ce premier mode de réalisation, la couche piézoélectrique 116 est en contact avec la couche de silicium et/ou de nitrure de silicium de la membrane 108 uniquement par l'intermédiaire de couches métalliques qui correspondent ici à la deuxième électrode 112 et à la couche d'accroche 114.

Dans ce dispositif 100, l'absence de couche de SiO₂ entre la couche piézoélectrique 116 et la membrane 108 ne pose pas de problème de décollement du matériau piézoélectrique lors de la réalisation du dispositif 100 car, comme cela est décrit plus loin, au cours du procédé de réalisation du dispositif 100, la couche piézoélectrique 116 n'est pas réalisée à partir de la membrane 108 mais sur un substrat temporaire différent du substrat 102.

Le dispositif 100 selon un deuxième mode de réalisation, également connu des documents pré-cités, est décrit ci-dessous en lien avec la figure 2.

Comme dans le premier mode de réalisation, le dispositif 100 selon ce deuxième mode de réalisation comporte le substrat 102, les première et deuxième couches d'oxyde 104, 106, la membrane 108, la cavité 110 et la couche piézoélectrique 116.

Par contre, contrairement au premier mode de réalisation dans lequel les première et deuxième électrodes 112, 118 sont disposées sur les deux faces principales de la couche piézoélectrique 116, le dispositif 100 selon le deuxième mode de réalisation comporte des première et deuxième électrodes 120, 122 disposées sur une seule face de la couche piézoélectrique 116, appelée première face 124. La deuxième face 126 de la couche piézoélectrique 116, opposée à la première face 124, est en contact direct avec la membrane 108. Les première et deuxième électrodes 120, 122 sont ici réalisées selon un motif de peignes interdigités, et sont par exemple issues d'une même couche métallique.

Dans ce deuxième mode de réalisation, le dispositif 100 fonctionne en utilisant le coefficient piézoélectrique longitudinal d33 du matériau piézoélectrique.

Comme dans le premier mode de réalisation, l'absence de couche de SiO₂ entre la couche piézoélectrique 116 et la membrane 108 ne pose pas de problème de décollement du matériau de la couche piézoélectrique 116 car, comme cela est décrit plus loin, au cours du procédé de réalisation du dispositif 100, la couche piézoélectrique 116 n'est pas réalisée sur la membrane 108 mais sur un substrat temporaire différent du substrat 102. En outre, l'absence de couche métallique entre la couche piézoélectrique 116 et la membrane 108 n'est pas problématique pour la réalisation du matériau piézoélectrique de la couche 116 puisque la couche piézoélectrique 116 n'est pas réalisée à partir de la membrane 108 mais sur un substrat temporaire sur lequel une couche métallique peut être disposée pour former la couche piézoélectrique 116.

Dans ce deuxième mode de réalisation, la couche piézoélectrique 116 est en contact direct avec la couche de silicium et/ou de nitrure de silicium de la membrane 108.

En variante, comme dans le premier mode de réalisation, la membrane 108 peut correspondre à une couche de SiO₂ disposée entre deux couches de silicium et/ou de nitrure de silicium.

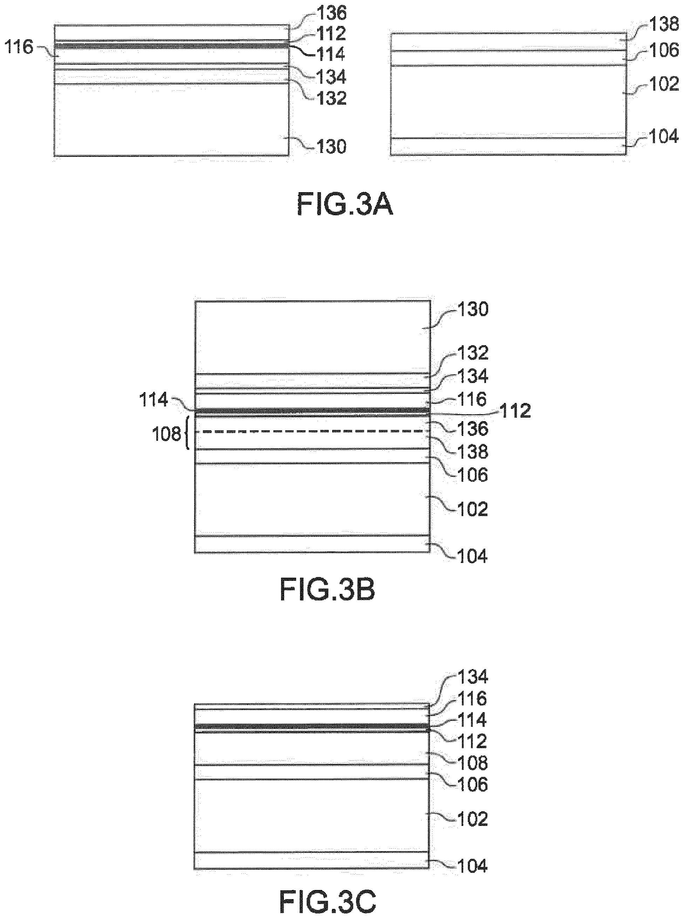

Un exemple de procédé de réalisation du dispositif 100 selon le premier mode de réalisation d'invention est décrit ci-dessous en lien avec les figures 3A à 3C.

Comme représenté sur la figure 3A, on réalise tout d'abord sur un substrat temporaire 130, qui correspond ici à un substrat de semi-conducteur comprenant par exemple du silicium, et dont l'épaisseur est par exemple comprise entre environ 100 µm et 1 mm, une interface de faible adhérence destinée à former ultérieurement une interface de séparation pour détacher le substrat temporaire 130 des éléments du dispositif 100.

Cette interface de faible force d'adhérence est formée par une première couche de séparation 132 comprenant ici au moins du SiO₂ et/ou du nitrure de silicium tel que du SiN et/ou du Si₃N₄, et une deuxième couche de séparation 134 comprenant au moins un métal noble. L'interface de faible force d'adhérence correspond à l'interface entre ces deux couches de séparation 132, 134, et est obtenue grâce à la nature des matériaux des couches de séparation 132, 134 qui n'adhèrent que faiblement l'un à l'autre.

Le matériau de la première couche de séparation 132 peut correspondre avantageusement à du SiO₂. La première couche de séparation 132 est par exemple réalisée par oxydation thermique de la face supérieure du substrat temporaire 130. L'épaisseur de la première couche de séparation 132 est par exemple comprise entre environ 1 nm et 20 µm, et ici par exemple égale à environ 500 nm.

De manière optionnelle, il est possible de mettre en œuvre une désoxydation de la face arrière du substrat temporaire 130 afin de retirer l'oxyde formé sur la face arrière du substrat temporaire 130 lors de l'étape précédente d'oxydation formant la première couche de séparation 132.

Le métal noble de la deuxième couche de séparation 134, par exemple réalisée par un dépôt PVD (dépôt physique en phase vapeur) du métal noble sur la première couche de séparation 132, comporte au moins l'un des éléments suivants : platine, or, argent, rhodium, osmium, palladium, ruthénium, iridium. Du fait que cette deuxième couche de séparation 134 est ici destinée à servir à la réalisation de la première électrode 118 et à servir à la croissance du matériau piézoélectrique de la couche piézoélectrique 116, cette deuxième couche de séparation 134 comporte avantageusement du platine. L'épaisseur de la deuxième couche de séparation 134 est par exemple comprise entre environ 1 nm et 200 nm, et ici par exemple égale à environ 100 nm.

La couche piézoélectrique 116 est ensuite réalisée sur la deuxième couche de séparation 134, par exemple par un procédé sol-gel du matériau piézoélectrique, avantageusement du PZT. Un recuit de cristallisation et de densification du matériau piézoélectrique de la couche 116 est notamment mis en œuvre à ce stade du procédé au cours de la réalisation de la couche piézoélectrique 116.

La couche destinée à former la deuxième électrode 112 est ensuite déposée sur la couche piézoélectrique 116. Dans l'exemple de réalisation décrit ici, ce dépôt est précédé d'un dépôt de la couche d'accroche 114 afin de favoriser l'accroche du métal déposé ensuite pour former la deuxième électrode 112.

Une première couche de collage 136, correspondant ici à une couche de silicium et/ou de nitrure de silicium, est ensuite réalisée sur la deuxième électrode 112. Dans le procédé de réalisation décrit ici, cette première couche de collage est destinée à assurer le collage des couches réalisées sur le substrat temporaire 130 avec le substrat 102 (substrat receveur) du dispositif 100, mais également à former une partie de la membrane 108. L'épaisseur de la première couche de collage 136 est par exemple comprise entre environ 1 nm et 1 mm, en fonction notamment de l'épaisseur souhaitée pour la membrane 108. Dans l'exemple de réalisation décrit ici, la première couche de collage 136 comporte du silicium et une épaisseur égale à environ 500 nm. La première couche de collage 136 est par exemple réalisée par dépôt PVD.

Parallèlement à ces étapes, le substrat 102 est préparé pour recevoir l'empilement de matériaux formé sur le substrat temporaire 130. Les faces avant et arrière du substrat 102 sont par exemple oxydées, formant les première et deuxième couches d'oxyde 104, 106. Une deuxième couche de collage 138, correspondant ici à une couche de silicium et/ou de nitrure de silicium, est déposée sur la deuxième couche d'oxyde 106, et est adaptée pour pouvoir être collée par collage direct avec la première couche de collage 136. Cette deuxième couche de collage 138 est par exemple similaire à la première couche de collage 136, et correspond ici à une couche de silicium d'épaisseur égale à environ 500 nm.

Chacune des deux couches de collage 136, 138 a ici des propriétés adaptées à un collage direct : très faible rugosité, matériau adapté, etc.

Un collage direct est ensuite réalisé entre les deux couches de collage 136, 138 (figure 3B). Au sein de l'empilement ainsi obtenu, l'interface de faible force d'adhérence formée entre les couches de séparation 132, 134 correspond, parmi toutes les interfaces de l'empilement, à celle qui présente la plus faible force d'adhérence entre deux couches successives de l'empilement. En outre, la couche de silicium obtenue par le collage direct des couches de collage 136, 138 va permettre de former la membrane 108.

La deuxième couche d'oxyde 106 sert de couche d'isolation électrique entre le substrat 102 et les autres couches disposées sur la deuxième couche d'oxyde 106.

Une séparation mécanique est ensuite réalisée au niveau de l'interface de faible force d'adhérence entre les couches de séparation 132, 134 (figure 3C). Cette séparation mécanique est par exemple réalisée en introduisant une lame entre les deux wafers. La deuxième couche de séparation 134 est ensuite gravée telle qu'au moins une portion restante de cette deuxième couche de séparation 134 forme la première électrode 118. En variante, il est possible de supprimer complètement la deuxième couche de séparation 134, puis de déposer une nouvelle couche électriquement conductrice adaptée à la réalisation de la première électrode 118.

Le dispositif 100 est achevé en gravant, depuis la première couche d'oxyde 104 et à travers les couches d'oxyde 104, 106 et le substrat 102, la cavité 110, libérant ainsi la membrane 108. Le dispositif 100 obtenu correspond à celui représenté sur la figure 1.

A l'issue de ce procédé de réalisation, le substrat temporaire 130 peut être réutilisé pour réaliser d'autres dispositifs.

Dans l'exemple de réalisation décrit ici, la face arrière du substrat 102 est recouverte de la couche d'oxyde 104. En variante, il est possible de supprimer cette couche d'oxyde 104 est réalisant une désoxydation de la face arrière du substrat 102, comme pour le substrat temporaire 130.

Dans le procédé décrit en lien avec les figures 3A à 3C, la première couche de séparation 132 comporte du SiO₂ et/ou du nitrure de silicium et la deuxième couche de séparation 134 comporte le métal noble. Cela est avantageux lorsque le matériau de la deuxième couche de séparation 134 est utilisé ensuite pour la réalisation de la première électrode 118. Selon une variante de réalisation, il est toutefois possible que la première couche de séparation 132 comporte le métal noble et que la deuxième couche de séparation 134 comporte le SiO₂ et/ou le nitrure de silicium. Dans ce cas, après la séparation mécanique entre les couches de séparation 132, 134, la deuxième couche de séparation 134 est gravée puis une couche électriquement conductrice est déposée et gravée pour réaliser la première électrode 118.

Dans le procédé de réalisation précédemment décrit, l'interface de faible force d'adhérence est formée grâce aux propriétés intrinsèques des matériaux des couches de séparation 132, 134, du fait que du SiO₂ et/ou du nitrure de silicium et un métal noble adhérent peu l'un à l'autre.

En variante, il est possible que la faible force d'adhérence de l'interface entre le substrat temporaire 130 et les couches du dispositif 100 à transférer sur le substrat définitif (substrat 102) du dispositif 100 soit obtenue grâce à la mise en œuvre d'au moins une étape spécifique dégradant volontairement les propriétés d'adhérence de cette interface et réduisant la force d'adhérence à cette interface entre les matériaux des première et deuxième couches de séparation 132, 134. A titre d'exemple, lors du dépôt de la couche piézoélectrique 116 sur la deuxième couche de séparation 134, il est possible de mettre en œuvre un traitement thermique faisant diffuser des atomes de plomb issus du PZT de la couche piézoélectrique 116 vers le SiO₂ de la première couche de séparation 132, à travers la deuxième couche de séparation 134 qui comporte par exemple du platine. Avec un tel traitement thermique, par exemple mis en œuvre à une température supérieure ou égale à environ 700°C, un mélange SiO₂ + Pb en phase liquide se forme à l'interface entre les première et deuxième couches de séparation 132, 134. Lorsque la température descend, des cavités se créent alors à cette interface, dans la couche formée du mélange de SiO₂ et de plomb. Ces cavités réduisent l'adhérence entre les couches de séparation 132, 134.

Cette dégradation, ou réduction, de la force d'adhérence de l'interface entre les couches de séparation 132, 134 peut donc être réalisée lorsque les propriétés intrinsèques des matériaux utilisés pour ces couches de séparation 132, 134 n'engendrent pas, sans intervention supplémentaire, la formation d'une interface de faible force d'adhérence. Ainsi, d'autres matériaux, comme par exemple du TiO₂, du ZrO₂ ou bien encore du ZnO ou du Ta₂O₅, peuvent être utilisés pour former l'une des deux couches de séparation 132, 134.

Dans le procédé précédemment décrit, la membrane 108 correspond à une couche de silicium et/ou de nitrure de silicium formée par la solidarisation des deux couches de collage 136, 138 l'une contre l'autre. En variante, il est possible que la première couche de collage 136 corresponde à un empilement d'une première couche de silicium et/ou de nitrure de silicium et d'une première couche de SiO₂ telles que cette première couche de silicium et/ou de nitrure de silicium soit disposée entre la première couche de SiO₂ et la couche piézoélectrique 116. La deuxième couche de collage 138 comporte dans ce cas également une deuxième couche de silicium et/ou de nitrure de silicium et une deuxième couche de SiO₂ telles que la deuxième couche de silicium et/ou de nitrure de silicium soit disposée entre la deuxième couche de SiO₂ et le deuxième substrat 102. L'étape de solidarisation correspond alors à un collage direct entre les première et deuxième couches de SiO₂, formant une membrane 108 comprenant une couche de SiO₂ disposée entre deux couches de silicium et/ou de nitrure de silicium.

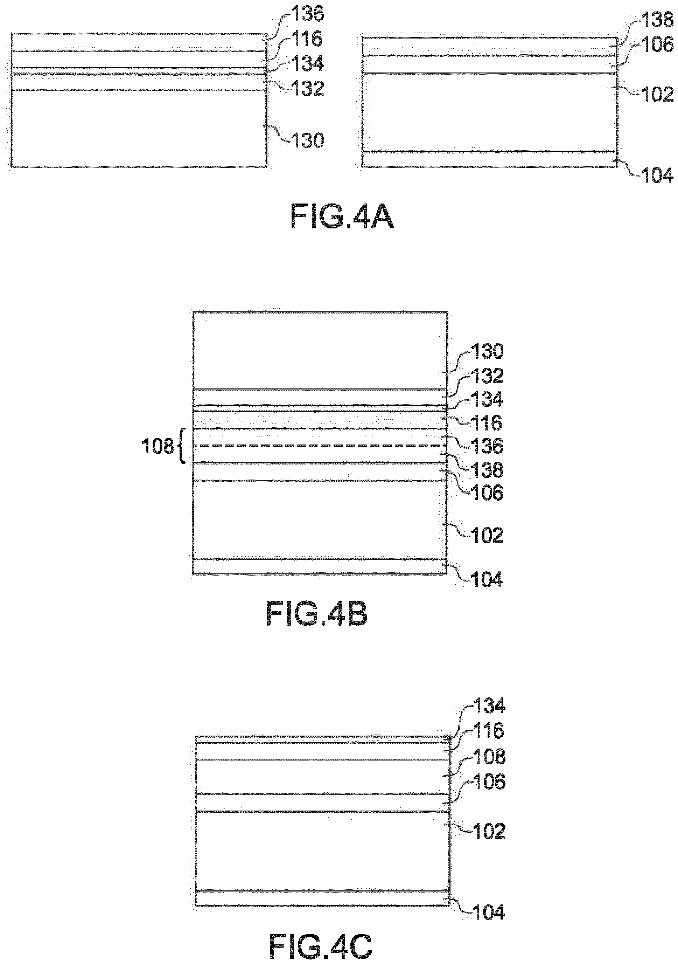

Un exemple de procédé de réalisation du dispositif 100 selon le deuxième mode de réalisation d'invention est décrit ci-dessous en lien avec les figures 4A à 4C.

Comme dans le procédé de réalisation précédemment décrit en lien avec les figures 3A - 3C, les couches 116, 134, 132 sont réalisées sur le substrat donneur 130. Etant donné que les électrodes 120, 122 du dispositif 100 ne seront disposées que sur la première face 124 de la couche piézoélectrique 116, aucune couche d'électrode n'est réalisée sur la couche piézoélectrique 116. La première couche de collage 136 est donc réalisée sur la couche piézoélectrique 116, en contact direct avec elle.

Parallèlement à ces étapes, et comme dans le procédé précédemment décrit en lien avec les figures 3A-3C, le substrat 102 est préparé pour recevoir l'empilement de matériaux formé sur le substrat temporaire 130, via la formation des première et deuxième couches d'oxyde 104, 106 et de la deuxième couche de collage 138 (figure 4A).

Les couches de collage 136, 138 sont ensuite solidarisées l'une à l'autre par la mise en œuvre d'un collage direct (figure 4B).

Une séparation mécanique est ensuite réalisée au niveau de l'interface de plus faible force d'adhérence, entre les couches de séparation 132, 134, avec la première couche de séparation 132 qui reste solidaire du substrat donneur 130, et la deuxième couche de séparation 134 qui reste solidaire des couches présentes sur le substrat 102 (figure 4C).

La deuxième couche de séparation 134 peut ensuite être gravée pour former les première et deuxième électrodes 120, 122 du dispositif 100.

Les différentes variantes de mise en œuvre du procédé de réalisation précédemment décrites pour la réalisation du dispositif 100 selon le premier mode de réalisation peuvent également s'appliquer au procédé de réalisation du dispositif 100 selon le deuxième mode de réalisation.

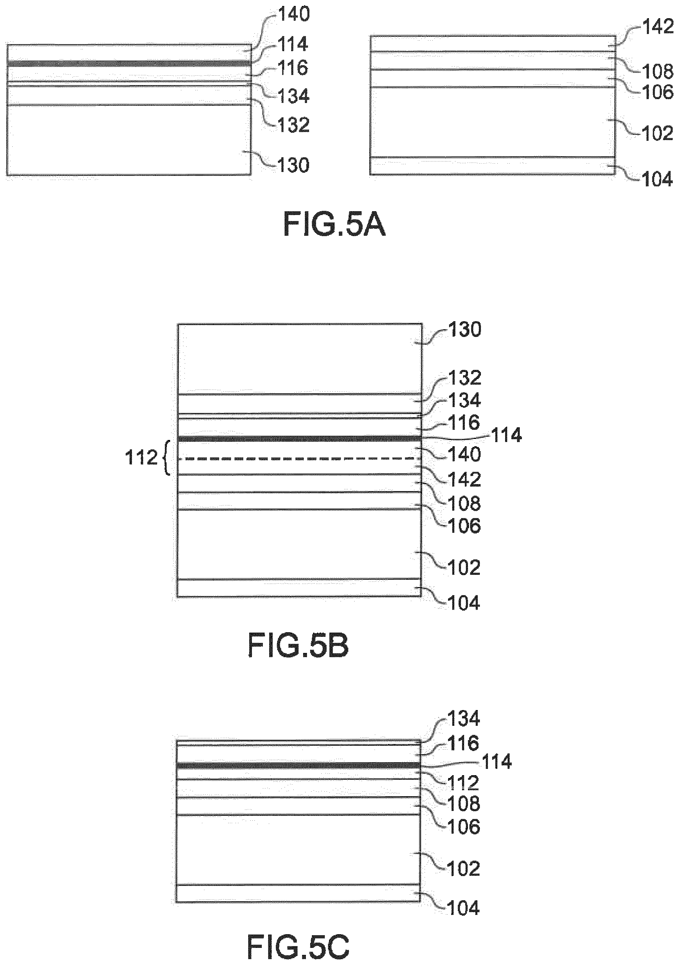

Un autre procédé de réalisation du dispositif 100 selon le premier mode de réalisation d'invention est décrit ci-dessous en lien avec les figures 5A-5C.

Comme dans le procédé de réalisation précédemment décrit en lien avec les figures 3A - 3C, les couches 114, 116, 134, 132 sont réalisées sur le substrat temporaire 130.

Dans cet autre mode de réalisation, la deuxième électrode 112 est destinée à être formée par deux couches de collage métalliques 140, 142 solidarisées l'une à l'autre. Une première couche de collage métallique 104 est réalisée sur la couche d'accroche 114.

Parallèlement à ces étapes, et comme dans le procédé précédemment décrit en lien avec les figures 3A-3C, le substrat 102 est préparé pour recevoir l'empilement de matériaux formé sur le substrat temporaire 130, via la formation des première et deuxième couches d'oxyde 104, 106. Toutefois, dans cet autre procédé de réalisation, étant donné que les deux couches de collage utilisées pour solidariser le substrat temporaire 130 au substrat définitif 102 sont destinées à former ensemble la deuxième électrode 112 et non la membrane 108, au moins une couche de silicium et/ou de nitrure de silicium configurée pour former la membrane 108 est déposée sur la deuxième couche d'oxyde 106. La deuxième couche de collage métallique 142 est ensuite réalisée sur la membrane 108 (figure 5A). En variante, il est également possible que la deuxième couche de collage métallique 142 soit formée sur une membrane 108 correspondant à une couche de SiO₂ disposée entre deux couches de silicium et/ou de nitrure de silicium (l'une de ces deux couches de silicium et/ou de nitrure de silicium étant disposée entre la couche de SiO₂ et le substrat 102, et l'autre des deux couches de silicium et/ou de nitrure de silicium étant disposée entre la couche de SiO₂ et la deuxième couche de collage métallique 142).

Ces couches de collage métalliques 140, 142 correspondent par exemple à des couches comprenant du cuivre et/ou de l'or, et dont l'épaisseur est par exemple comprise entre environ 1 nm et 100 µm. Dans l'exemple décrit ici, chacune des couches de collage métalliques 140, 142 comporte de l'or et une épaisseur égale à environ 50 nm.

Un collage direct ou par thermocompression est ensuite mis en œuvre entre les deux couches de collage métalliques 140, 142. Dans le cas d'un collage par thermocompression, celui-ci est par exemple mis en œuvre à une température comprise entre environ 20°C et 400°C, et par exemple inférieure à environ 150°C, en appliquant une force de compression comprise entre environ 1 kN et 50 kN, et pendant une durée par exemple comprise entre environ 1 min et 30 min. La force et la durée avec lesquelles le collage par thermocompression est mis en œuvre sont fonction notamment des épaisseurs des couches de collage métalliques 140, 142. Les paramètres de mise en œuvre de cette thermocompression sont adaptés notamment en fonction des propriétés des couches de collage métalliques 140, 142.

Dans la structure obtenue, les couches de collage métalliques 140, 142 forment ensemble la deuxième électrode 112 (figure 5B).

Une séparation mécanique est ensuite réalisée au niveau de l'interface de plus faible force d'adhérence, entre les couches de séparation 132, 134, avec la première couche de séparation 132 qui reste solidaire du substrat donneur 130, et la deuxième couche de séparation 134 qui reste solidaire des couches présentes sur le substrat 102 (figure 5C).

La deuxième couche de séparation 134 peut ensuite est gravée pour former la première électrode 118 du dispositif 100.

Les différentes variantes de mise en œuvre du procédé de réalisation précédemment décrites pour la réalisation du dispositif 100 selon le premier mode de réalisation peuvent également s'appliquer à cet autre procédé de réalisation du dispositif 100.

## Revendications

1. Procédé de réalisation d'un dispositif (100) transducteur piézoélectrique, comportant au moins :
- réalisation, sur une face d'un premier substrat (130), de première et deuxième couches de séparation (132, 134) disposées l'une contre l'autre et telles que la première couche de séparation (132) soit disposée entre le premier substrat (130) et la deuxième couche de séparation (134) ;
- réalisation, sur la deuxième couche de séparation (134), d'au moins une couche piézoélectrique (116) comprenant au moins un matériau piézoélectrique de structure cristalline pérovskite ;
- solidarisation de la couche piézoélectrique (116) à un deuxième substrat (102), formant un empilement de différents matériaux dans lequel la couche piézoélectrique (116) est disposée entre le deuxième substrat (102) et la deuxième couche de séparation (134), et dans lequel au moins une membrane (108) comprenant au moins une couche de silicium et/ou de nitrure de silicium est disposée entre la couche piézoélectrique (116) et le deuxième substrat (102) telle que la couche piézoélectrique (116) soit en contact direct avec la couche de silicium et/ou de nitrure de silicium de la membrane (108), ou que la couche piézoélectrique (116) soit en contact avec la couche de silicium et/ou de nitrure de silicium de la membrane (108) uniquement par l'intermédiaire d'une ou plusieurs couches électriquement conductrices ;
- séparation mécanique au niveau d'une interface entre les première et deuxième couches de séparation (132, 134), telle que la première couche de séparation (132) reste solidaire du premier substrat (130) et que la deuxième couche de séparation (134) reste solidaire de la couche piézoélectrique (116) ;
comportant en outre, au cours du procédé, la réalisation de première et deuxième électrodes (112, 118, 120, 122) en contact électriquement avec la couche piézoélectrique (116),
et dans lequel les matériaux de l'empilement sont choisis tels que l'interface entre les première et deuxième couches de séparation (132, 134) correspond à celle, parmi toutes les interfaces de l'empilement, ayant la plus faible force d'adhérence, et dans lequel :
- l'une des première et deuxième couches de séparation (132, 134) comporte au moins du SiO₂ et/ou du nitrure de silicium et l'autre des première et deuxième couches de séparation (132, 134) comporte au moins un métal noble, et/ou
- le procédé comporte, entre l'étape de réalisation des première et deuxième couches de séparation (132, 134) et l'étape de solidarisation, la mise en œuvre d'au moins une étape réduisant une force d'adhérence initiale de l'interface entre les première et deuxième couches de séparation (132,134).

2. Procédé selon la revendication 1, comportant en outre, entre l'étape de réalisation de la couche piézoélectrique (116) et l'étape de solidarisation de la couche piézoélectrique (116) au deuxième substrat (102), une étape de réalisation, sur la couche piézoélectrique (116), d'une première couche de collage (136) comprenant du silicium et/ou du nitrure de silicium, et dans lequel :
- l'étape de solidarisation est mise en œuvre par un collage direct entre la première couche de collage (136) et une deuxième couche de collage (138) comprenant du silicium et/ou du nitrure de silicium et disposée sur le deuxième substrat (102) ;
- la réalisation de la membrane (108) comporte une étape de réalisation d'une cavité (110) dans le deuxième substrat (102) telle qu'une partie des première et deuxième couches de collage (136, 138) disposée en regard de la cavité (110) forme la membrane (108).

3. Procédé selon la revendication 2, comportant en outre, entre l'étape de réalisation de la couche piézoélectrique (116) et l'étape de réalisation de la première couche de collage (136), une étape de réalisation, sur la couche piézoélectrique (116), d'au moins une couche métallique configurée pour former la deuxième électrode (112) du dispositif (100), et dans lequel la première électrode (118) est réalisée sur la couche piézoélectrique (116) après l'étape de séparation mécanique.

4. Procédé selon la revendication 3, dans lequel la deuxième couche de séparation (134) comporte le métal noble, et dans lequel la première électrode (118) est réalisée en gravant la deuxième couche de séparation (134) telle qu'au moins une portion restante de la deuxième couche de séparation (134) forme la première électrode (118).

5. Procédé selon la revendication 2, dans lequel la première couche de collage (136) est réalisée directement contre la couche piézoélectrique (116), et dans lequel les première et deuxième électrodes (120, 122) sont réalisées sur la couche piézoélectrique (116) après l'étape de séparation mécanique.

6. Procédé selon la revendication 5, dans lequel la deuxième couche de séparation (134) comporte le métal noble, et dans lequel les première et deuxième électrodes (120, 122) sont réalisées en gravant la deuxième couche de séparation (134) telle que des portions restantes de la deuxième couche de séparation (134) forment les première et deuxième électrodes (120, 122) ayant un motif de peignes interdigités.

7. Procédé selon l'une des revendications 2 à 6, dans lequel la première couche de collage (136) comporte une première couche de silicium et/ou de nitrure de silicium et une première couche de SiO₂ telles que la première couche de silicium et/ou de nitrure de silicium soit disposée entre la première couche de SiO₂ et la couche piézoélectrique (116), et dans lequel la deuxième couche de collage (138) comporte une deuxième couche de silicium et/ou de nitrure de silicium et une deuxième couche de SiO₂ telles que la deuxième couche de silicium et/ou de nitrure de silicium soit disposée entre la deuxième couche de SiO₂ et le deuxième substrat (102).

8. Procédé selon la revendication 1, comportant en outre, entre l'étape de réalisation de la couche piézoélectrique (116) et l'étape de solidarisation de la couche piézoélectrique (116) au deuxième substrat (102), une étape de réalisation, sur la couche piézoélectrique (116), d'une première couche de collage métallique (140), et dans lequel :
- l'étape de solidarisation est mise en œuvre par un collage direct ou par thermocompression entre la première couche de collage métallique (140) et une deuxième couche de collage métallique (142) solidarisée au deuxième substrat (102) par l'intermédiaire de la couche de silicium et/ou de nitrure de silicium de la membrane (108) ;
- la réalisation de la membrane (108) comporte une étape de réalisation d'une cavité (110) dans le deuxième substrat (102) telle qu'une partie de la couche de silicium et/ou de nitrure de silicium disposée en regard de la cavité (110) forme au moins une partie de la membrane (108) ;
- les première et deuxième couches de collage métalliques (140, 142) forment ensemble la deuxième électrode (112) du dispositif (100).

9. Procédé selon la revendication 8, dans lequel la deuxième couche de séparation (134) comporte le métal noble, et dans lequel la première électrode (118) est réalisée en gravant la deuxième couche de séparation (134) telle qu'au moins une portion restante de la deuxième couche de séparation (134) forme la première électrode (118).

10. Procédé selon l'une des revendications 8 ou 9, dans lequel la membrane (108) comporte au moins une couche de SiO₂ disposée entre deux couches de silicium et/ou de nitrure de silicium.

11. Procédé selon l'une des revendications précédentes, dans lequel le métal noble comporte du platine.

12. Procédé selon l'une des revendications précédentes, dans lequel :
- le matériau piézoélectrique comporte du plomb ;
- la première couche de séparation (132) comporte du SiO₂ ;
- ladite au moins une étape réduisant la force d'adhérence initiale de l'interface entre les première et deuxième couches de séparation (132, 134) comporte la mise en œuvre d'au moins un traitement thermique formant, à l'interface entre les première et deuxième couches de séparation (132, 134), un alliage de plomb et de SiO₂ en phase liquide, puis d'un refroidissement formant des cavités à l'interface entre les première et deuxième couches de séparation (132, 134).

## Patentansprüche

1. Verfahren zur Herstellung einer piezoelektrischen Wandlervorrichtung (100), welches wenigstens umfasst:
- Herstellen einer ersten und einer zweiten Trennschicht (132, 134) auf einer Seite eines ersten Substrats (130), die aneinander angeordnet sind, und derart, dass die erste Trennschicht (132) zwischen dem ersten Substrat (130) und der zweiten Trennschicht (134) angeordnet ist;
- Herstellen wenigstens einer piezoelektrischen Schicht (116) auf der zweiten Trennschicht (134), die wenigstens ein piezoelektrisches Material mit einer Perowskit-Kristallstruktur umfasst;
- Verbinden der piezoelektrischen Schicht (116) mit einem zweiten Substrat (102) unter Bildung eines Stapels aus verschiedenen Materialien, wobei die piezoelektrische Schicht (116) zwischen dem zweiten Substrat (102) und der zweiten Trennschicht (134) angeordnet ist, und wobei wenigstens eine Membran (108), die wenigstens eine Silizium- und/oder Siliziumnitridschicht umfasst, zwischen der piezoelektrischen Schicht (116) und dem zweiten Substrat (102) derart angeordnet ist, dass die piezoelektrische Schicht (116) in direktem Kontakt mit der Silizium- und/oder Siliziumnitridschicht der Membran (108) steht, oder dass die piezoelektrische Schicht (116) mit der Silizium- und/oder Siliziumnitridschicht der Membran (108) nur mittels einer oder mehrerer elektrisch leitender Schichten in Kontakt steht;
- mechanische Trennung an einer Grenzfläche zwischen der ersten und der zweiten Trennschicht (132, 134), derart dass die erste Trennschicht (132) integral mit dem ersten Substrat (130) verbunden bleibt und die zweite Trennschicht (134) integral mit der piezoelektrischen Schicht (116) verbunden bleibt;
ferner umfassend im Verlauf des Verfahrens die Herstellung einer ersten und
einer zweiten Elektrode (112, 118, 120, 122) in elektrischem Kontakt mit der piezoelektrischen Schicht (116),
und wobei die Materialien des Stapels derart gewählt sind, dass die Grenzfläche zwischen der ersten und der zweiten Trennschicht (132, 134) derjenigen von allen Grenzflächen des Stapels entspricht, die die geringste Adhäsionskraft aufweist,
und wobei:
- eine von erster und zweiter Trennschicht (132, 134) wenigstens SiO₂ und/oder Siliziumnitrid umfasst und die andere von erster und zweiter Trennschicht (132, 134) wenigstens ein Edelmetall umfasst, und/oder
- das Verfahren zwischen dem Schritt der Herstellung der ersten und zweiten Trennschicht (132, 134) und dem Schritt des Verbindens die Durchführung wenigstens eines Schrittes umfasst, der eine anfängliche Adhäsionskraft der Grenzfläche zwischen der ersten und zweiten Trennschicht (132, 134) reduziert.

2. Verfahren nach Anspruch 1, ferner umfassend zwischen dem Schritt des Herstellens der piezoelektrischen Schicht (116) und dem Schritt des Verbindens der piezoelektrischen Schicht (116) mit dem zweiten Substrat (102) einen Schritt des Herstellens einer ersten Klebeschicht (136) auf der piezoelektrischen Schicht (116), welche Silizium und/oder Siliziumnitrid umfasst, und wobei:
- der Verbindungsschritt durch direktes Kleben zwischen der ersten Klebeschicht (136) und einer zweiten Klebeschicht (138), welche Silizium und/oder Siliziumnitrid umfasst und auf dem zweiten Substrat (102) angeordnet ist, ausgeführt wird;
- die Herstellung der Membran (108) einen Schritt des Herstellens eines Hohlraums (110) in dem zweiten Substrat (102) umfasst, derart dass ein Teil der ersten und zweiten Klebeschicht (136, 138), der dem Hohlraum (110) zugewandt angeordnet ist, die Membran (108) bildet.

3. Verfahren nach Anspruch 2, ferner umfassend zwischen dem Schritt des Herstellens der piezoelektrischen Schicht (116) und dem Schritt des Herstellens der ersten Klebeschicht (136) einen Schritt des Herstellens wenigstens einer Metallschicht auf der piezoelektrischen Schicht (116), welche dazu ausgebildet ist, die zweite Elektrode (112) der Vorrichtung (100) zu bilden, und wobei die erste Elektrode (118) auf der piezoelektrischen Schicht (116) nach dem Schritt des mechanischen Trennens hergestellt wird.

4. Verfahren nach Anspruch 3, wobei die zweite Trennschicht (134) das Edelmetall umfasst, und wobei die erste Elektrode (118) durch Ätzen der zweiten Trennschicht (134) hergestellt wird, so dass zumindest ein verbleibender Teil der zweiten Trennschicht (134) die erste Elektrode (118) bildet.

5. Verfahren nach Anspruch 2, wobei die erste Klebeschicht (136) direkt gegen die piezoelektrische Schicht (116) hergestellt wird, und wobei die erste und zweite Elektrode (120, 122) auf der piezoelektrischen Schicht (116) nach dem Schritt des mechanischen Trennens hergestellt werden.

6. Verfahren nach Anspruch 5, wobei die zweite Trennschicht (134) das Edelmetall umfasst, und wobei die erste und zweite Elektrode (120, 122) durch Ätzen der zweiten Trennschicht (134) hergestellt werden, so dass die verbleibenden Teile der zweiten Trennschicht (134) die erste und zweite Elektrode (120, 122) mit einem ineinandergreifenden Kamm-Muster bilden.

7. Verfahren nach einem der Ansprüche 2 bis 6, wobei die erste Klebeschicht (136) eine erste Silizium- und/oder Siliziumnitridschicht und eine erste SiO₂-Schicht umfasst, so dass die erste Silizium- und/oder Siliziumnitridschicht zwischen der ersten SiO₂-Schicht und der piezoelektrischen Schicht (116) angeordnet ist, und wobei die zweite Klebeschicht (138) eine zweite Silizium- und/oder Siliziumnitridschicht und eine zweite SiO₂-Schicht umfasst, so dass die zweite Silizium- und/oder Siliziumnitridschicht zwischen der zweiten SiO₂-Schicht und dem zweiten Substrat (102) angeordnet ist.

8. Verfahren nach Anspruch 1, ferner umfassend zwischen dem Schritt des Herstellens der piezoelektrischen Schicht (116) und dem Schritt des Verbindens der piezoelektrischen Schicht (116) mit dem zweiten Substrat (102) einen Schritt des Herstellens einer ersten Metallklebeschicht (140) auf der piezoelektrischen Schicht (116), und wobei:
- der Verbindungsschritt durch direktes Kleben oder durch Thermokompression zwischen der ersten Metallklebeschicht (140) und einer zweiten Metallklebeschicht (142), die mittels der Silizium- und/oder Siliziumnitridschicht der Membran (108) mit dem zweiten Substrat (102) verbunden ist, durchgeführt wird;
- die Herstellung der Membran (108) einen Schritt des Herstellens eines Hohlraums (110) in dem zweiten Substrat (102) umfasst, so dass ein Teil der Silizium- und/oder Siliziumnitridschicht, die dem Hohlraum (110) zugewandt angeordnet ist, wenigstens einen Teil der Membran (108) bildet;
- die erste und die zweite Metallklebeschicht (140, 142) zusammen die zweite Elektrode (112) der Vorrichtung (100) bilden.

9. Verfahren nach Anspruch 8, wobei die zweite Trennschicht (134) das Edelmetall umfasst, und wobei die erste Elektrode (118) durch Ätzen der zweiten Trennschicht (134) hergestellt wird, so dass zumindest ein verbleibender Teil der zweiten Trennschicht (134) die erste Elektrode (118) bildet.

10. Verfahren nach einem der Ansprüche 8 oder 9, wobei die Membran (108) wenigstens eine SiO₂-Schicht umfasst, die zwischen zwei Silizium- und/oder Siliziumnitridschichten angeordnet ist.

11. Verfahren nach einem der vorhergehenden Ansprüche, wobei das Edelmetall Platin umfasst.

12. Verfahren nach einem der vorhergehenden Ansprüche, wobei:
- das piezoelektrische Material Blei umfasst;
- die erste Trennschicht (132) SiO₂ umfasst;
- wobei der wenigstens eine Schritt, der die anfängliche Adhäsionskraft der Grenzfläche zwischen der ersten und der zweiten Trennschicht (132, 134) verringert, die Durchführung wenigstens einer Wärmebehandlung umfasst, die an der Grenzfläche zwischen der ersten und der zweiten Trennschicht (132, 134) eine Legierung aus Blei und SiO₂ in der flüssigen Phase bildet, gefolgt von einer Abkühlung, welche Hohlräume an der Grenzfläche zwischen der ersten und der zweiten Trennschicht (132, 134) bildet.

## Claims

1. Method for producing a piezoelectric transducer device (100), comprising at least:
- producing, on a face of a first substrate (130), first and second separation layers (132, 134) arranged one against the other and such that the first separation layer (132) is arranged between the first substrate (130) and the second separation layer (134);
- producing, on the second separation layer (134), at least one piezoelectric layer (116) including at least one piezoelectric material with crystalline perovskite structure;
- making the piezoelectric layer (116) integral with a second substrate (102), forming a stack of different materials in which the piezoelectric layer (116) is arranged between the second substrate (102) and the second separation layer (134), and in which at least one membrane (108) including at least one silicon and/or silicon nitride layer is arranged between the piezoelectric layer (116) and the second substrate (102) such that the piezoelectric layer (116) is in direct contact with the silicon and/or silicon nitride layer of the membrane (108), or that the piezoelectric layer (116) is in contact with the silicon and/or silicon nitride layer of the membrane (108) solely through one or more electrically conductive layers;
- mechanical separation at an interface between the first and second separation layers (132, 134), such that the first separation layer (132) remains integral with the first substrate (130) and that the second separation layer (134) remains integral with the piezoelectric layer (116);
further comprising, in the course of the method, the production of first and second electrodes (112, 118, 120, 122) electrically in contact with the piezoelectric layer (116),
and in which the materials of the stack are chosen such that the interface between the first and second separation layers (132, 134) corresponds to that, among all the interfaces of the stack, having the lowest adherence force, and in which:
- one of the first and second separation layers (132, 134) comprises at least SiO₂ and/or silicon nitride and the other of the first and second separation layers (132, 134) comprises at least one noble metal, and/or
- the method comprises, between the step of producing the first and second separation layers (132, 134) and the making integral step, the implementation of at least one step reducing an initial adherence force of the interface between the first and second separation layers (132, 134).

2. Method according to claim 1, further comprising, between the step of producing the piezoelectric layer (116) and the step of making the piezoelectric layer (116) integral with the second substrate (102), a step of producing, on the piezoelectric layer (116), a first bonding layer (136) including silicon and/or silicon nitride, and in which:
- the making integral step is implemented by direct bonding between the first bonding layer (136) and a second bonding layer (138) including silicon and/or silicon nitride and arranged on the second substrate (102);
- the production of the membrane (108) comprises a step of producing a cavity (110) in the second substrate (102) such that a part of the first and second bonding layers (136, 138) arranged facing the cavity (110) forms the membrane (108).

3. Method according to claim 2, further comprising, between the step of producing the piezoelectric layer (116) and the step of producing the first bonding layer (136), a step of producing, on the piezoelectric layer (116), at least one metal layer configured to form the second electrode (112) of the device (100), and in which the first electrode (118) is produced on the piezoelectric layer (116) after the mechanical separation step.

4. Method according to claim 3, in which the second separation layer (134) comprises the noble metal, and in which the first electrode (118) is produced by etching the second separation layer (134) such that at least one remaining portion of the second separation layer (134) forms the first electrode (118).

5. Method according to claim 2, in which the first bonding layer (136) is produced directly against the piezoelectric layer (116), and in which the first and second electrodes (120, 122) are produced on the piezoelectric layer (116) after the mechanical separation step.

6. Method according to claim 5, in which the second separation layer (134) comprises the noble metal, and in which the first and second electrodes (120,122) are produced by etching the second separation layer (134) such that the remaining portions of the second separation layer (134) form the first and second electrodes (120, 122) having an interdigitated comb pattern.

7. Method according to one of claims 2 to 6, in which the first bonding layer (136) comprises a first silicon and/or silicon nitride layer and a first SiO₂ layer such that the first silicon and/or silicon nitride layer is arranged between the first SiO₂ layer and the piezoelectric layer (116), and in which the second bonding layer (138) comprises a second silicon and/or silicon nitride layer and a second SiO₂ layer such that the second silicon and/or silicon nitride layer is arranged between the second SiO₂ layer and the second substrate (102).

8. Method according to claim 1, further comprising, between the step of producing the piezoelectric layer (116) and the step of making the piezoelectric layer (116) integral with the second substrate (102), a step of producing, on the piezoelectric layer (116), a first metal bonding layer (140), and in which:
- the making integral step is implemented by direct bonding or by thermocompression between the first metal bonding layer (140) and a second metal bonding layer (142) made integral with the second substrate (102) through the silicon and/or silicon nitride layer of the membrane (108);
- the production of the membrane (108) comprises a step of producing a cavity (110) in the second substrate (102) such that a part of the silicon and/or silicon nitride layer arranged facing the cavity (110) forms at least one part of the membrane (108);
- the first and second metal bonding layers (140, 142) form together the second electrode (112) of the device (100).

9. Method according to claim 8, in which the second separation layer (134) comprises the noble metal, and in which the first electrode (118) is produced by etching the second separation layer (134) such that at least one remaining portion of the second separation layer (134) forms the first electrode (118).

10. Method according to one of claims 8 or 9, in which the membrane (108) comprises at least one SiO₂ layer arranged between two silicon and/or silicon nitride layers.

11. Method according to one of previous claims, in which the noble metal comprises platinum.

12. Method according to one of previous claims, in which:
- the piezoelectric material comprises lead;
- the first separation layer (132) comprises SiO₂;
- said at least one step reducing the initial adherence force of the interface between the first and second separation layers (132, 134) comprises the implementation of at least one thermal treatment forming, at the interface between the first and second separation layers (132, 134), an alloy of lead and SiO₂ in liquid phase, then a cooling forming cavities at the interface between the first and second separation layers (132, 134).
